# EUROPEAN PATENT APPLICATION

(11) **EP 4 760 775 A1**
(43) Date of publication of application: **17.06.2026**
(21) Application number: 24219026.2
(22) Date of filing: 11.12.2024
(51) Int. Cl.: H01L 21/20, H10D 30/01, H10D 30/47

(54) **WAFER COMPRISING A MULTILAYERED STRUCTURE AND METHOD OF PRODUCING A WAFER COMPRISING A MULTILAYERED STRUCTURE**

(71) Applicant: Siltronic AG, 81677 München (DE)
(72) Inventor: Michler, Sondre, 84489 Burghausen (DE); Thapa, Sarad Bahadur, 84453 Mühldorf (DE)
(74) Representative: Killinger, Andreas

(57) **Abstract**

A wafer comprising a multilayered structure, wherein the multilayered structure comprises in this order
a silicon substrate;
a buffer structure; and
one or more monocrystalline device layers having a total thickness of not less than 80 nm and not more than 1000 nm and comprising at least one GaN layer;
the buffer structure comprising in this order
at least one AIN nucleation layer;
an Al_{z}Ga_{1-z}N layer;
at least one superlattice structure comprising 20 to 120 periods, each period consisting of a layer of AlₓGa₁₋ₓN and a layer of Al_{y}Ga_{1-y}N; and
a monocrystalline GaN buffer layer having a carbon concentration of not less than 1 × 10¹⁸ cm⁻³ and not more than 1 × 10²⁰ cm⁻³ and a thickness of not less than 0.5 µm and not more than 4 µm;
wherein 0.3≤z≤0.7; 0.6≤x≤1.0; and 0≤y≤0.4; and
characterized in that
at least one of the at least one superlattice structure comprises carbon in a concentration of not less than 1 × 10¹⁷ cm⁻³ and not more than 1 × 10²⁰ cm⁻³, and
the buffer structure comprises islands having a layered structure and consisting of alternating layers of AlₓGa₁₋ₓN and Al_{y}Ga_{1-y}N, the islands being located in-between the Al_{z}Ga_{1-z}N layer and the at least one superlattice structure consisting of alternating layers of AlₓGa₁₋ₓN and Al_{y}Ga_{1-y}N.

## Description

### Technical Field

The present invention is directed to a wafer comprising a multilayered structure and a method of producing a wafer comprising a multilayered structure.

### Discussion of Prior Art

In modern electronics, gallium nitride (GaN) power devices have attracted increased attention due to their higher frequency operation, lower switching losses, and high-voltage operation capability. Lateral GaN structures are suitable materials for lateral high electron mobility transistors (HEMTs) for high power applications (>650 V), for example in electric vehicles, smart grids and renewable energy processes.

For such devices, relatively thin device layers of heteroepitaxial GaN films are deposited on a silicon wafer, with a buffer structure in between. The deposition of a buffer is necessary because of the lattice mismatch and the mismatch between the coefficients of thermal expansion of Si and GaN. Since the electric breakdown field of Si is ten times lower than GaN, the breakdown voltage is dictated by the thickness and quality of the buffer. EP 3 451 364 B1 describes that a thick buffer is beneficial for suppressing vertical leakage current and improving the breakdown performance of AIGaN/GaN HEMTs. EP 3 451 364 B1 further discloses the use of an insulating GaN buffer containing carbon.

EP 2 727 133 B1 discloses a GaN structure with a buffer layer comprising two translation layers of the composition B_{w}AlₓGa_{y}In_{z}N. Thus, a GaN layer having a thickness of more than 5 µm and a relatively low dislocation density can be obtained. Yet, the buffer layer is relatively thick and complex. Y. Zhang et al. J. Phys. D: Appl. Phys. 51 (2018) 273001 describe a buffer layer which enables the preparation of a GaN layer having a dislocation density of 2 × 10⁸ cm⁻² and a thickness of less than 6 µm. A. Dadgar et al. Phys. Stat. Sol. (C) 0, No. 6 (2003) describe the reduction of dislocations by a superlattice structure having 15 periods. It is explained that dislocations are bent at the interfaces of the layers of the superlattice, thereby increasing the probability of recombination and annihilation with other dislocations with opposite burgers vector. The mechanism of annihilation of dislocations in such multilayered structures is also discussed by A. E. Romanov and J. S. Speck. Appl. Phys. Lett. 83.13 (2003): 2569-2571; by B. Daudin, B. et al. Phys. Rev. B 56.12 (1997): R7069; and by M. Imura et al. J. Cryst. Growth 300.1 (2007): 136-140.

EP 3 352 199 A1 is directed to a III-N based substrate for power electronic devices comprising a base substrate and a buffer layer structure between the base substrate and the III-N laminate. The buffer layer structure comprises at least a first superlattice laminate and a second superlattice laminate.

Even in the presence of such buffer, the lattice mismatch results in a relatively high defect density in the GaN device layers. Moreover, the different coefficients of thermal expansion can lead to cracks if the GaN layer exceeds a certain thickness. To account for the different coefficient of thermal expansion, sufficient compressive stress must be incorporated into a GaN layer during growth to counteract the tensile stress to which it is subjected during the cooling process. There is thus a need for improved lateral GaN structures with new buffer layers that enable the fabrication of GaN device layers with low defect density, low vertical leakage current, and increased thickness of the buffer.

### Objective and Solution Provided by the Invention

The present invention aims at providing a multilayered GaN structure which (i) is suitable for lateral devices, in particular lateral HEMTs, (ii) exhibits reduced dislocation density and stress in the GaN device layers, and (iii) exhibits improved breakdown performance.

The above problem is solved by the wafer according to the first aspect of the present invention. The wafer comprises a multilayered structure, wherein the multilayered structure comprises in this order
a silicon substrate;
a buffer structure; and
one or more monocrystalline device layers having a total thickness of not less than 80 nm and not more than 1000 nm and comprising at least one GaN layer;
the buffer structure comprising in this order
at least one AIN nucleation layer;
an Al_{z}Ga_{1-z}N layer;
at least one superlattice structure comprising 20 to 120 periods, each period consisting of a layer of AlₓGa₁₋ₓN and a layer of Al_{y}Ga_{1-y}N; and
a monocrystalline GaN buffer layer having a carbon concentration of not less than 1 × 10¹⁸ cm⁻³ and not more than 1 × 10²⁰ cm⁻³ and a thickness of not less than 0.5 µm and not more than 4 µm;
wherein 0.3≤z≤0.7; 0.6≤x≤1.0; and 0≤y≤0.4; and
characterized in that
at least one of the at least one superlattice structure comprises carbon in a concentration of not less than 1 × 10¹⁷ cm⁻³ and not more than 1 × 10²⁰ cm⁻³, and
the buffer structure comprises islands having a layered structure and consisting of alternating layers of AlₓGa₁₋ₓN and Al_{y}Ga_{1-y}N, the islands being located in-between the Al_{z}Ga_{1-z}N layer and the at least one superlattice structure consisting of alternating layers of AlₓGa₁₋ₓN and Al_{y}Ga_{1-y}N.

The inventors found that specific process conditions induce the growth of islands having a layered structure and consisting of alternating layers of AlₓGa₁₋ₓN and islands of Al_{y}Ga_{1-y}N, with 0.6≤x≤1.0 and 0≤y≤0.4, followed by growth of a superlattice comprised of layers of these materials. It has been surprisingly found that the presence of such islands reduces the dislocations in a comparatively small section of the superlattice structure of the buffer structure. These islands annihilate dislocations and reduce compressive stress relaxation during GaN growth. Thus, sufficiently high compressive stress is maintained, so that the tensile stress during cooling can be compensated. As a result, a low dislocation density and low leakage current in vertical direction can be obtained.

In addition, as dislocations, in particular threading dislocations, can be efficiently reduced in a comparatively small section of the superlattice structure of the buffer structure, the thickness of the buffer as a whole can be reduced. This is advantageous as this allows to reduce production costs and enhances heat transport through the buffer during operation of the device. It was also found that the incorporation of carbon in the superlattice structure is beneficial in terms of reducing the vertical leakage current and the buffer dispersion (contribution to current collapse).

In a second aspect, the present invention is directed to a method of producing a wafer comprising a multilayered structure. The method comprises the following steps in this order
(i) providing a silicon substrate;
(ii) flowing a gas stream which comprises an aluminum precursor and no nitrogen precursor over the substrate at a temperature of not less than 700 °C and not more than 900 °C so that the total amount of aluminum flown over the substrate is not less than 0.1 µmol and not more than 250 µmol;
(iii) depositing at least one AIN nucleation layer by flowing a gas stream comprising an aluminum precursor and a nitrogen precursor over the substrate at a temperature of not less than 700 °C and not more than 1100 °C, preferably a low temperature AIN nucleation layer is deposited first, and subsequently a high temperature AIN nucleation layer is deposited;
(iv) depositing an Al_{z}Ga_{1-z}N layer with 0.3≤z≤0.7 by flowing a gas stream comprising an aluminum precursor, a gallium precursor and a nitrogen precursor over the substrate at a temperature of not less than 950 °C and not more than 1050 °C,
(v) depositing alternately AlₓGa₁₋ₓN with 0.6≤x≤1.0 and Al_{y}Ga_{1-y}N with 0≤y≤0.4 for 20 to 120 cycles by flowing a gas stream comprising an aluminum precursor, a gallium precursor and a nitrogen precursor over the substrate at a temperature of not less than 900°C and not more than 1100°C, wherein the alternation of the deposition is achieved by changing the composition of the gas stream; and
(vi) depositing a monocrystalline GaN buffer layer by flowing a gas stream comprising a gallium precursor, a nitrogen precursor and a carbon precursor over the substrate at a temperature of not less than 950°C and not more than 1100°C;
(vii) depositing one or more monocrystalline GaN device layers by flowing a gas stream comprising a gallium precursor, a nitrogen precursor and optionally a dopant precursor over the substrate at a temperature of not less than 900°C and not more than 1200°C;
characterized in that in at least one of steps (iv) and (v) the gas stream additionally comprises a metal-free carbon precursor.

The method according to the second aspect is suitable for preparing the wafer comprising a multilayered structure according to the first aspect. Thus, the present invention provides a method susceptible for industrial application for obtaining the wafer according to the first aspect of the present invention.

### Detailed Description of the Invention

In the following, the wafer comprising a multilayered structure according to the first aspect of the present invention is described in detail. The multilayered structure comprises in this order
a silicon substrate;
a buffer structure; and
one or more monocrystalline device layers having a total thickness of not less than 80 nm and not more than 1000 nm and comprising at least one GaN layer;
the buffer structure comprising in this order
at least one AIN nucleation layer;
an Al_{z}Ga_{1-z}N layer;
at least one superlattice structure comprising 20 to 120 periods, each period consisting of a layer of AlₓGa₁₋ₓN and a layer of Al_{y}Ga_{1-y}N; and
a monocrystalline GaN buffer layer having a carbon concentration of not less than 1 × 10¹⁸ cm⁻³ and not more than 1 × 10²⁰ cm⁻³ and a thickness of not less than 0.5 µm and not more than 4 µm;
wherein 0.3≤z≤0.7; 0.6≤x≤1.0; and 0≤y≤0.4; and
characterized in that
at least one of the at least one superlattice structure comprises carbon in a concentration of not less than 1 × 10¹⁷ cm⁻³ and not more than 1 × 10²⁰ cm⁻³, and
the buffer structure comprises islands having a layered structure and consisting of alternating layers of AlₓGa₁₋ₓN and Al_{y}Ga_{1-y}N, the islands being located in-between the Al_{z}Ga_{1-z}N layer and the at least one superlattice structure consisting of alternating layers of AlₓGa₁₋ₓN and Al_{y}Ga_{1-y}N.

The silicon substrate has preferably a <111>-orientation. More particularly, the silicon substrate is preferably a monocrystalline silicon wafer having a <111>-orientation, a wafer comprising a silicon on insulator (SOI) structure having a <111>-orientation, or a ceramic substrate with a silicon seed layer having a <111>-orientation. The ceramic substrate may for example be a substrate of the type QST provided by Qromis, Inc. The substrate is preferably a wafer having a diameter of not less than 150 mm and not more than 300 mm, preferably not less than 150 mm and not more than 210 mm. In a particularly preferred embodiment, the silicon substrate has a diameter of 150 mm or 200 mm. The monocrystalline silicon wafer has preferably a thickness of not less than 625 µm and not more than 1500 µm. The silicon substrate is optionally doped and may have a silicon oxide or silicon nitride protection layer on its backside and/or its bevel. The substrate preferably consists of boron-doped monocrystalline silicon.

The buffer structure comprises in this order at least one AIN nucleation layer; an Al_{z}Ga_{1-z}N layer; at least one superlattice structure comprising 20 to 120 periods, each period consisting of a layer of AlₓGa₁₋ₓN and a layer of Al_{y}Ga_{1-y}N; and a monocrystalline GaN buffer layer having a carbon concentration of not less than 1 × 10¹⁸ cm⁻³ and not more than 1 × 10²⁰ cm⁻³ and a thickness of not less than 0.5 µm and not more than 4 µm.

The at least one AIN nucleation layer may consist of a single high temperature AIN nucleation layer. The at least one AIN nucleation layer preferably comprises a low temperature AIN nucleation layer and a high temperature AIN nucleation layer. The total thickness of the at least one AIN nucleation layer is preferably not less than 50 nm and not more than 500 nm. Preferably, the high temperature AIN nucleation layer is located on top of the low temperature AIN nucleation layer.

A low temperature AIN nucleation layer within the meaning of the present invention is a layer of the composition AIN deposited by metalorganic chemical vapour deposition (MOCVD) at a temperature of not more than 900°C. The low temperature AIN nucleation layer is formed on top of the silicon substrate. It has preferably a thickness of not less than 1 nm and not more than 50 nm. The purpose of the low temperature AIN nucleation layer is to provide a high density of nucleation sites on the silicon substrate to promote the growth of a continuous high temperature AIN layer, avoiding large pits. The low temperature AIN nucleation layer is formed by flowing a gas stream comprising an aluminum precursor and a nitrogen precursor over the substrate at a temperature of not less than 700 °C and not more than 900 °C.

A high temperature AIN nucleation layer within the meaning of the present invention is a layer of the composition AIN deposited by metalorganic chemical vapour deposition (MOCVD) at a temperature of not less than 950°C. The high temperature AIN nucleation layer is preferably formed on top of the low temperature AIN layer. It has preferably a thickness of not less than 50 nm and not more than 500 nm, more preferably of not less than 100 nm and not more than 300 nm. The high temperature AIN nucleation layer is deposited to protect the silicon substrate from meltback-etching that occurs when Ga is in contact with silicon at elevated temperatures. The high temperature AIN nucleation layer is deposited by flowing a gas stream comprising an aluminum precursor and a nitrogen precursor over the substrate, which optionally has a low temperature AIN nucleation layer on top, at a temperature of not less than 950°C and not more than 1100 °C.

The Al_{z}Ga_{1-z}N layer is formed on top of the at least one AIN nucleation layer, preferably on top of the high temperature AIN nucleation layer, and has an Al content defined by 0.3≤z≤0.7. More preferably, the Al_{z}Ga_{1-z}N layer has a composition defined by 0.4≤z≤0.6, most preferably 0.45≤z≤0.55. The Al_{z}Ga_{1-z}N layer has preferably a thickness of not less than 10 nm and not more than 400 nm, more preferably not less than 20 nm and not more than 200 nm, and most preferably not more than 100 nm. The effect of the Al_{z}Ga_{1-z}N layer is to smoothen the surface after AIN growth and to annihilate dislocations. Preferably, the Al_{z}Ga_{1-z}N layer is under compressive stress. If the Al_{z}Ga_{1-z}N layer is under compressive stress, a change of the curvature of the wafer is initiated, so that the multilayered structure is less concave as compared to its curvature after deposition of the at least one AIN nucleation layer and before the Al_{z}Ga_{1-z}N deposition. The Al_{z}Ga_{1-z}N layer is deposited by flowing a gas stream comprising an aluminum precursor, a gallium precursor and a nitrogen precursor, and optionally a carrier gas such as hydrogen or nitrogen, over the substrate with the low and the high temperature AIN layers at a temperature of not less than 950 °C and not more than 1050 °C.

Islands are located in-between the Al_{z}Ga_{1-z}N layer and the at least one superlattice structure consisting of alternating layers of AlₓGa₁₋ₓN and Al_{y}Ga_{1-y}N, with 0.6≤x≤1.0, and 0≤y≤0.4. The islands have a layered structure and consist of alternating layers of AlₓGa₁₋ₓN and Al_{y}Ga_{1-y}N. Preferably, the islands consist of not less than 2 and not more than 30 layers, more preferably not less than 5 and not more than 20 layers. The islands are preferably located in-between the Al_{z}Ga_{1-z}N layer and the first period of the first superlattice structure consisting of alternating layers of AlₓGa₁₋ₓN and Al_{y}Ga_{1-y}N, wherein the alternating layers of AlₓGa₁₋ₓN and Al_{y}Ga_{1-y}N in the superlattice structure are flat, continuous and parallel to the main surface of the silicon substrate.

In a preferred embodiment of the present invention, the total density of the islands is preferably not less than 1.0×10⁷ cm⁻² and not more than 1.0×10¹⁰ cm⁻², more preferably, not less than 5.0×10⁷ cm⁻² and not more than 5.0×10⁹ cm⁻². The total density of islands within the meaning of the present invention is determined from plan-view, i.e. when viewed from an axial direction. The axis of the axial direction is the rotational axis of the wafer. In other words, the island density refers to the density of islands in a plane parallel to the wafer surface and located between the Al_{z}Ga_{1-z}N layer and the continuous alternating layers of AlₓGa₁₋ₓN and Al_{y}Ga_{1-y}N. The island density is preferably determined after not less than 5 cycles, more preferably after not less than 10 and not more than 20 cycles, of depositing alternately AlₓGa₁₋ₓN with 0.6≤x≤1.0 and Al_{y}Ga_{1-y}N with 0≤y≤0.4. In other words, it is preferable to determine the island density close to the time of coalescence, before the formation of continuous layers of the superlattice structure is induced. If the island density is in the above range, the annihilation of dislocations can be further improved, resulting in an even lower dislocation density in the subsequently deposited layers. More particularly, if the island density is in the range of 1.0×10⁷ cm⁻² to 1.0×10¹⁰ cm⁻², the distance between the islands is ideal for the islands to coalesce, so that the thickness at the time of coalescence of adjacent islands is relatively low and vertical growth between the islands is suppressed. This leads to a further reduction of the dislocation density. Even though an island density of 1.0×10⁷ cm⁻² to 1.0×10¹⁰ cm⁻² is beneficial, such density is not an essential feature of the present invention.

Preferably, the islands have a height of not less than 100 nm and not more than 1000 nm. More preferably, the islands have a height (or maximum thickness) of not less than 160 nm and not more than 450 nm. The height or maximum thickness preferably corresponds to the thickness at the point of coalescence. The height is the maximum extension of an island in a direction perpendicular to the surface of the wafer (axial direction), i.e. in a direction perpendicular to the surface of the silicon substrate. If the height of the islands falls within the range of 100 to 1000 nm, the annihilation of dislocations is further improved and thermally induced stress is further compensated. In the present invention, the height of the islands is also referred to as thickness of the islands. Even though a height of the islands of 100 to 1000 nm is beneficial, it is not an essential feature of the present invention. The islands may thus also have a height outside this range.

Preferably, the islands may have an aspect ratio of not less than 0.1 and not more than 100, more preferably not less than 0.1 and not more than 10. The aspect ratio is the ratio of width to height of an island. The width is the maximum diameter of an island in a plane parallel to the wafer surface, i.e. the maximum width in a plane parallel to the surface of the silicon substrate. Thus, the maximum width is determined in plan-view of the wafer. The height and diameter of the islands and the island density can be determined by means of scanning electron microscopy (SEM). The height and diameter of the islands and the island density can also be determined by means of transmission electron microscopy (TEM) or atomic force microscopy (AFM), wherein the latter requires growth interruption at different stages of the growth of the islands. SEM is a comparatively fast method for analyzing the geometry of the islands, i.e. the height and width of the islands. In addition, SEM allows to analyze a larger area and the cross-section to be analyzed can be easily prepared by mechanically dicing the wafer. Therefore, the total density of islands, their aspect ratio and the height of the islands can preferably be determined by means of scanning electron microscopy (SEM).

The aspect ratio within the meaning of the present invention is preferably a median aspect ratio, which is the median value of the aspect ratios of at least 100 islands. The aspect ratio is preferably in the range of 0.1 to 100. If the aspect ratio is in this range, the height of the islands at the time of coalescence is optimized, so that an ideal balance of (i) compensating thermally induced stress during cooling and (ii) reducing the dislocation density is achieved. However, said aspect ratio is not an essential feature of the present invention. In other words, if the aspect ratio is outside the range of 0.1 to 100, the problem underlying the present invention, namely providing a multilayered GaN structure exhibiting reduced dislocation density and stress in the GaN device layers and exhibiting improved breakdown performance, is also achieved.

It is noted that the thickness, width and aspect ratios of the islands as described above constitute preferred embodiments of the present invention and are not essential for carrying out the present invention and solving the above-mentioned problem.

After 5 to 20 periods of depositing alternately AlₓGa₁₋ₓN and Al_{y}Ga_{1-y}N, coalescence takes place and, thus, the deposition of continuous layers is initiated on top of the islands. Generally, in the present application, the parameters x and y are in the following ranges: 0.6≤x≤1.0 and 0.0≤y≤0.4.

When the deposition of continuous layers is initiated, at least one superlattice structure is formed. A superlattice structure is a periodic structure of alternating layers of two materials, wherein the thickness of one period is in the nanometer range. In the present invention, the term superlattice structure refers to a periodic structure of two or more materials, wherein each period has a thickness in the nanometer range and contains two or more continuous layers. In one embodiment, the superlattice structure is a periodic structure of two materials, wherein each period has a thickness in the nanometer range and contains two continuous layers The term continuous or closed layer within the meaning of the present invention refers to a uniform layer covering more than 90%, preferably more than 95%, and most preferably more than 98% of the underlying surface of the semiconductor wafer on which it is deposited. The terms continuous and closed are used synonymously. At least one of the at least one superlattice structure comprises carbon in a concentration of not less than 1 × 10¹⁷ cm⁻³ and not more than 1 × 10²⁰ cm⁻³, preferably not less than 1 × 10¹⁸ cm⁻³ and not more than 1 × 10²⁰ cm⁻³.

The layers in the periodic structure are preferably continuous layers. In the present invention, the superlattice structure comprises 20 to 120, preferably 20 to 100, more preferably 20 to 60, periods, wherein each period consists of a, preferably continuous, layer of AlₓGa₁₋ₓN and a, preferably continuous, layer of Al_{y}Ga_{1-y}N, with 0.6≤x≤1.0 and 0.0≤y≤0.4, preferably 0.70≤x≤1.00 and 0.05≤y≤0.30, most preferred 0.80≤x≤1.00 and 0.05≤y≤0.20. In a particularly preferred embodiment, the superlattice structure comprises 20 to 40 periods. Preferably, each period of the superlattice structure has a thickness of not less than 18 nm and not more 50 nm. More preferably, in each period of the superlattice structure, the layer of AlₓGa₁₋ₓN has preferably a thickness of not less than 2 nm and not more than 15 nm and the layer of A_{y}Ga_{1-y}N has preferably a thickness of not less than 15 nm and not more than 35 nm. The average Al content of the superlattice structure is preferably less than 50 wt.%. Dislocations are also bent at the interfaces between each layer of AlₓGa₁₋ₓN and each layer of Al_{y}Ga_{1-y}N, due to the strain field, which also results in a higher probability of annihilation. Thus, the superlattice structure promotes the annihilation of dislocations, so that the dislocation density in the layers deposited on top of the superlattice structure is further reduced. A sufficient annihilation of dislocation is achieved when the superlattice structure contains at least 20 periods. The superlattice structure preferably contains 20 to 100 periods, more preferably 20 to 60 periods, most preferably 20 to 40 periods of continuous layers.

In a preferred embodiment of the present invention, the buffer structure consists of a first superlattice structure and a second superlattice structure atop the first superlattice structure, wherein each of the two superlattice structures comprises 20 to 120 periods, with each period consisting of a layer of AlₓGa₁₋ₓN and a layer of Al_{y}Ga_{1-y}N. The overall Al concentration in a superlattice structure can be altered by changing the thickness of the layers therein. Thus, different proportion of Al_{y}Ga_{1-y}N to AlₓGa₁₋ₓN in the second superlattice compared to the first super lattice can be obtained by changing the thickness of these layers.

The first and second superlattice structure preferably differ in at least one of x and y. More preferably, the first and second superlattice structure differ in both of x and y. Preferably, the average Al concentration in the second superlattice structure is lower than the average Al concentration in the first superlattice structure. Preferably, the second superlattice structure comprises carbon in a concentration of not less than 1 x 10¹⁸ cm⁻³ and not more than 1 × 10²⁰ cm⁻³. The second superlattice structure has preferably more layers than the first superlattice structure. More preferably, the second superlattice structure comprises 50 to 100 periods. When the buffer structure comprises a second superlattice structure, which comprises carbon, the resistivity of the buffer structure can be further improved. Thus, the leakage current is further reduced and the blocking voltage is increased.

The buffer structure further contains a monocrystalline GaN buffer layer having a carbon concentration of not less than 1 × 10¹⁸ cm⁻³ and not more than 1 × 10²⁰ cm⁻³ and a thickness of not less than 0.5 µm and not more than 4 µm. Carbon atoms in GaN or AlGaN layers on the nitrogen sites (C_{N}) act as a deep acceptors. Large concentrations of carbon thus lead to insulating behavior and thus contribute to a significant increase in buffer resistivity. Hence, carbon doping is used in the buffer to decrease the leakage current and thus increase the blocking voltage. If the carbon concentration is in the range of not less than 1 × 10¹⁸ cm⁻³ and not more than 1 × 10²⁰ cm⁻³, current leakage can be suppressed or at least significantly reduced in high-electron-mobility-transistor device structures. The monocrystalline GaN buffer layer preferably has a carbon concentration of not less than 5 × 10¹⁸ cm⁻³ and not more than 5 × 10¹⁹ cm⁻³. If the carbon concentration is in this range, the resistivity of the buffer can be further improved. The thickness of the monocrystalline GaN buffer layer is preferably not less than 1.5 µm and not more than 3 µm. The monocrystalline GaN buffer layer is preferably located on top of the superlattice structure, preferably ontop of the second superlattice structure.

One or more monocrystalline device layers having a total thickness of not less than 80 nm and not more than 1000 nm, and comprising at least one GaN layer, is deposited on top of the buffer structure, preferably directly on top of the monocrystalline GaN buffer layer having a carbon concentration of not less than 1 × 10¹⁸ cm⁻³ and not more than 1 × 10²⁰ cm⁻³. In one embodiment, the one or more monocrystalline device layers comprises in this order, a GaN channel layer, an AlᵥGa₁₋ᵥN barrier layer and optionally a cap layer, wherein 0.05≤v≤1. The cap layer may be a GaN cap layer or an SiN cap layer and has preferably a thickness of not less than 0.5 nm and not more than 5 nm (D-mode with cap-layer).

In another embodiment, the one or more monocrystalline device layers comprises in this order, a GaN channel layer and an AlᵥGa₁₋ᵥN barrier layer, wherein 0.05≤v≤1 (D-mode without cap layer).

In a further embodiment, the one or more monocrystalline device layers comprises in this order, a GaN channel layer, an AlᵥGa₁₋ᵥN barrier layer, wherein 0.05≤v≤1, and an Mg-doped GaN layer comprising Mg (GaN:Mg) in a concentration of not less than 1 × 10¹⁸ cm⁻³ and not more than 1 × 10²⁰ cm⁻³ (E-mode with pGaN layer). The Mg-doped GaN layer has preferably a thickness of not less than 40 nm and not more than 250 nm.

In each of the above-mentioned embodiments, the one or more monocrystalline device layers (D-mode with cap-layer, D-mode without cap layer and E-mode with pGaN layer) may optionally contain an AIN spacer between the GaN channel layer and the AlᵥGa₁₋ᵥN barrier layer. The AIN spacer has preferably a thickness of not less than 0.25 nm and not more than 4 nm.

In each of the above-mentioned embodiments, the GaN channel layer preferably has a thickness of not less than 50 nm and not more than 500 nm. The AlᵥGa₁₋ᵥN barrier layer preferably has a thickness of not less than 4 nm and not more than 40 nm. The AlᵥGa₁₋ᵥN barrier layer preferably has a composition defined by 0.05≤v≤1.

The multilayered structure is suitable for a lateral device structure. More particularly, a wafer comprising a multilayered structure according to the first aspect of the present invention with one or more monocrystalline device layers comprising this order a GaN channel layer, an AlᵥGa₁₋ᵥN barrier layer and, optionally GaN cap layer, is suitable for the fabrication of lateral high electron mobility transistors (HEMTs) for high power applications (>650 V).

Preferably, the semiconductor wafer according to the first aspect of the present invention has an absolute wafer bow at room temperature of not more than 80 µm, more preferably not more than 50 µm, most preferably not more than 40 µm.

In the second aspect of the present invention, a method of producing a wafer comprising a multilayered structure is provided. The method comprises the following steps in this order:
(i) providing a silicon substrate;
(ii) flowing a gas stream which comprises an aluminum precursor and no nitrogen precursor over the substrate at a temperature of not less than 700 °C and not more than 900 °C so that the total amount of aluminum flown over the substrate is not less than 0.1 µmol and not more than 250 µmol;
(iii) depositing at least one AIN nucleation layer by flowing a gas stream comprising an aluminum precursor and a nitrogen precursor over the substrate at a temperature of not less than 700 °C and not more than 1100 °C;
(iv) depositing an Al_{z}Ga_{1-z}N layer with 0.3≤z≤0.7 by flowing a gas stream comprising an aluminum precursor, a gallium precursor and a nitrogen precursor over the substrate at a temperature of not less than 950 °C and not more than 1050 °C;
(v) depositing alternately AlₓGa₁₋ₓN with 0.6≤x≤1.0 and Al_{y}Ga_{1-y}N with 0≤y≤0.4 for 20 to 120 cycles by flowing a gas stream comprising an aluminum precursor, a gallium precursor and a nitrogen precursor over the substrate at a temperature of not less than 900°C and not more than 1100°C, wherein the alternation of the deposition is achieved by changing the composition of the gas stream; and
(vi) depositing a monocrystalline GaN buffer layer by flowing a gas stream comprising a gallium precursor, a nitrogen precursor and a carbon precursor over the substrate at a temperature of not less than 950°C and not more than 1100°C;
(vii) depositing one or more monocrystalline GaN device layers by flowing a gas stream comprising a gallium precursor, a nitrogen precursor and optionally a dopant precursor over the substrate at a temperature of not less than 900°C and not more than 1200°C;
characterized in that in at least one of steps (iv) and (v) the gas stream additionally comprises a metal-free carbon precursor.

The silicon substrate provided in step (i) has preferably a <111>-orientation. More particularly, the silicon substrate is preferably a silicon substrate as described in connection with the first aspect of the present invention. More particularly, the silicon substrate is preferably a monocrystalline silicon wafer having a <111>-orientation, a wafer comprising a silicon on insulator (SOI) structure having a <111>-orientation, or a ceramic substrate with a silicon seed layer having a <111>-orientation.

In step (ii), a gas stream comprising an aluminum precursor and no nitrogen precursor is flown over the substrate at a temperature of not less than 700 °C and not more than 900 °C, so that the total amount of aluminum flown over the substrate is not less than 0.1 µmol and not more than 250 µmol.

The partial pressure of the aluminum precursor in the gas flow (i.e. the aluminum concentration therein), the volumetric flow rate and the duration of step (ii) is adjusted so that the total amount of aluminum flown over the substrate in this step is not less than 0.1 µmol and not more than 250 µmol, preferably not less than 1 µmol and not more than 100 µmol. The total amount of aluminum flown over the substrate in step (ii) is calculated from the volumetric flow rate of the gas stream, the concentration or partial pressure of the aluminum precursor in the gas stream and the flow time, i.e. the time the gas stream is flown over the semiconductor wafer. Preferably, the time the gas stream is flown over the semiconductor wafer is not less than 2 and not more than 60 seconds, more preferably not less than 2 and not more than 20 seconds. This step is beneficial for preventing nitridation of the monocrystalline silicon substrate prior to the deposition of AIN.

In step (iii), at least one AIN nucleation layer is deposited by flowing a gas stream comprising an aluminum precursor and a nitrogen precursor over the substrate at a temperature of not less than 700 °C and not more than 1100 °C. Preferably, in step (iii), a low temperature AIN nucleation layer is deposited first, and subsequently a high temperature AIN nucleation layer is deposited. The low temperature AIN nucleation layer is deposited by flowing a gas stream comprising an aluminum precursor and a nitrogen precursor over the substrate at a temperature of not less than 700 °C and not more than 900 °C, preferably not less than 750 °C and not more than 850 °C. The low temperature AIN nucleation layer is preferably a layer as defined in the first aspect of the present invention and has the purpose of providing nucleation sites for the growth of the high temperature AIN layer. The high temperature AIN nucleation layer is deposited by flowing a gas stream comprising an aluminum precursor and a nitrogen precursor over the substrate at a temperature of not less than 950 °C and not more than 1100 °C, preferably not less than 1000 °C and not more than 1050 °C. The high temperature AIN nucleation layer is preferably a high temperature AIN nucleation layer as defined in the first aspect of the present invention.

Under the above-mentioned conditions, V-pits are formed in the AIN layers. V-pits are voids, which preferably have an inverse hexagonal pyramidal shape. The density and size of the V-pits depends on the conditions of AIN deposition. The V-pits were found to be associated with screw dislocations in the AIN layer and may serve as the source of island growth. The subsequently deposited Al_{z}Ga_{1-z}N layer is preferably deposited in the V-pits and the subsequent growth of islands occurs on such V-pits filled with Al_{z}Ga_{1-z}N. As a result, the island density is inter alia dependent on the growth conditions in steps (iii) and (iv). As explained above, the presence of islands promotes the annihilation of dislocations and thus reduces the dislocation density.

In step (iv), deposition of an Al_{z}Ga_{1-z}N layer with 0.3≤z≤0.7 occurs by flowing a gas stream comprising an aluminum precursor, a gallium precursor and a nitrogen precursor, and a carrier gas such as hydrogen and/or nitrogen, over the substrate at a temperature of not less than 950 °C and not more than 1050 °C, preferably not less than 980 °C and not more than 1030 °C. Under these conditions, islands are formed, resulting in a reduced dislocation density in the one or more monocrystalline GaN device layers. The Al_{z}Ga_{1-z}N layer is preferably an Al_{z}Ga_{1-z}N layer as defined in the first aspect of the present invention.

In step (v), AlₓGa₁₋ₓN with 0.6≤x≤1.0 and Al_{y}Ga_{1-y}N with 0≤y≤0.4 is deposited alternately for 20 to 120 cycles, preferably for 20 to 100 cycles, by flowing a gas stream comprising an aluminum precursor, a gallium precursor and a nitrogen precursor, and a carrier gas such as hydrogen and/or nitrogen, over the substrate at a temperature of not less than 900°C and not more than 1100°C, preferably at a temperature of not less than 1000°C and not more than 1100°C. The alternation of the deposition is achieved by changing the composition of the gas stream. Preferably, in step (v), AlₓGa₁₋ₓN with 0.70≤x≤1.00 and Al_{y}Ga_{1-y}N with 0.05≤y≤0.30 is deposited. Most preferably, AlₓGa₁₋ₓN with 0.80≤x≤1.00 and Al_{y}Ga_{1-y}N with 0.05≤y≤0.20 is deposited.

In at least one of steps (iv) and (v), the gas stream additionally comprises a metal-free carbon precursor. The carbon precursor is preferably a metal-free organic compound and more preferably an alkane or alkene. The metal-free organic compound is not an organometallic compound. The carbon precursor is most preferably an alkane or an alkene having not more than 6 carbon atoms. In a particularly preferable embodiment, the carbon precursor is an alkene having 2 to 6 carbon atoms. The carbon precursor is for example ethene. An organometallic compound within the meaning of the present invention is for example a gallium organic compound such as trimethyl gallium or triethyl gallium or an aluminum organic compound such as trimethyl aluminum.

In step (v), islands and a superlattice structure are formed. During the first cycles of step (v), preferably during at least 5 cycles, more preferably during the first 10 to 20 cycles, the vertical growth rate, i.e. the growth rate in a direction perpendicular to a plane of the monocrystalline silicon, preferably a substrate with a silicon surface having a <111>-orientation, is much higher compared to the horizontal growth rate, i.e. the growth rate along a plane of the silicon substrate. This result in the formation of islands during the first cycles, preferably during at least 5 cycles, more preferably during 10 to 20 cycles. The dimensions, shape and density of the islands is controlled by the process conditions, in particular the temperature, pressure and the atomic ratio of group (V) to group (III) elements in the gas phase, wherein only group (V) and group (III) elements from precursor compounds are taken into account. The process of island formation is also determined by the strain of the underlying layers. After the first cycles, preferably after not more than 20 cycles, the ratio of the vertical growth rate to the horizontal growth rate is decreased, so that the islands coalesce and continuous layers are deposited. During the transition from island growth to the deposition of continuous layers, new dislocations, in particular threading dislocations, can be generated at the coalescence boundaries. To further reduce the dislocation density, the superlattice is continued for at least 10 periods to prevent a high dislocation density and thus a fast relaxation of the initially compressive stressed GaN layer. Furthermore, the compressive stressed Al_{y}Ga_{1-y}N layer and tensile stressed AlₓGa₁₋ₓN layer collectively produce an effective lattice parameter, which can be altered by changing the Ga/AI ratio in the superlattice. This lattice parameter governs the amount of compressive stress in GaN.

Preferably, step (v) is carried out twice in a row. In a preferred embodiment, x and y are the same during the first and second execution of step (v). In the second execution of step (v), the conditions of the deposition are changed, so that the thickness of the alternately deposited layers of Al_{y}Ga_{1-y}N layer and AlₓGa₁₋ₓN layer are different compared to the first execution of step (v). In other words, while the composition of the Al_{y}Ga_{1-y}N layer and the AlₓGa₁₋ₓN layer remains the same in the first and second execution of step (v), the overall Al concentration is altered due to the different thickness of the layers and thus different proportion of Al_{y}Ga_{1-y}N to AlₓGa₁₋ₓN in the second superlattice compared to the first super lattice.

In one embodiment, the temperature during the second execution of step (v) is preferably not less than 930°C and not more than 1050°C. When the gas stream used during the second execution of step (v) does not comprise a carbon precursor as defined above, the deposition temperature during the second execution of step (v) is preferably not less than 930°C and not more than 990°C. In this case, the carbon to be incorporated in the superlattice during the second execution of step (v) may originate from the aluminum precursor or the gallium precursor, i.e. from an organometallic compound. In contrast, when the gas stream used during the second execution of step (v) comprises a metal-free carbon precursor as defined above, for example an alkene having 2 to 6 carbon atoms, the temperature during the second execution of step (v) is preferably not less than 1000°C and not more than 1050°C.

In step (vi), a monocrystalline GaN buffer layer is deposited by flowing a gas stream comprising a gallium precursor, a nitrogen precursor and a carbon precursor over the substrate at a temperature of not less than 950°C and not more than 1100°C. The carbon precursor is preferably an organic compound and more preferably an alkane or alkene. The carbon precursor is most preferably an alkane or an alkene having not more than 6 carbon atoms. In a particularly preferable embodiment, the carbon precursor is an alkene having 2 to 6 carbon atoms. The carbon precursor is for example ethene. The monocrystalline GaN buffer layer deposited in step (vi) is preferably a monocrystalline GaN buffer layer having a carbon concentration of not less than 1 × 10¹⁸ cm⁻³ and not more than 1 × 10²⁰ cm⁻³ and a thickness of not less than 0.5 µm and not more than 4 µm, as described in the first aspect of the present invention.

In step (vii), deposition of one or more monocrystalline GaN device layers occurs, by flowing a gas stream comprising a gallium precursor, a nitrogen precursor and optionally a dopant precursor over the substrate at a temperature of not less than 900°C and not more than 1200°C.

Preferably, a GaN channel layer, an AlᵥGa₁₋ᵥN barrier layer and optionally a GaN cap layer are deposited in this order, preferably directly on top of the monocrystalline GaN buffer layer having a carbon concentration of not less than 1 × 10¹⁸ cm⁻³ and not more than 1 × 10²⁰ cm⁻³. More particularly, the one or more monocrystalline GaN device layers is a set of GaN device layers as defined in the first aspect of the present invention (D-mode with cap-layer, D-mode without cap layer and E-mode with pGaN layer).

In at least one of steps (iv) and (v), the gas stream additionally comprises a carbon precursor, so that at least one of the Al_{z}Ga_{1-z}N layer and the at least one superlattice structure comprises carbon in a concentration of not less than 1 × 10¹⁷ cm⁻³ and not more than 1 × 10²⁰ cm⁻³. Preferably, both of the Al_{z}Ga_{1-z}N layer and the at least one superlattice structure comprise carbon in a concentration of not less than 1 × 10¹⁷ cm⁻³ and not more than 1 × 10²⁰ cm⁻³.

Generally, in each of steps (ii) to (iv), the gas stream satisfies an atomic ratio of group (V) elements resulting from the nitrogen precursor to group (III) elements resulting from the aluminum precursor and, if present, from the gallium precursor, of not less than 5 and not more than 500. Preferably, the said ratio is not less than 10 and not more than 60, when Ga free layers are grown. As N₂ is not considered as a precursor within the meaning of the present invention, the nitrogen originating from N₂ in the carrier gas is not taken into account, when calculating the above ratio. Preferably, the gas streams in steps (ii) to (v) contain one or more carrier gases selected from the group of hydrogen, nitrogen, helium and argon. More preferably, the gas stream in each of steps (ii) to (v) contains hydrogen or nitrogen as the carrier gas. In one embodiment, the aluminum precursor is trimethylaluminum, the gallium precursor is trimethylgallium and the nitrogen precursor is ammonia. Generally, the chemical composition of the deposited layers depends on the atomic ratio of group (V) elements resulting from the nitrogen precursor to group (III) elements resulting from the aluminum precursor and, if present, from the gallium precursor. The growth mode also depends on this ratio.

Preferably, the alternation of the deposition in each cycle of step (v) is achieved by changing the composition of the gas stream so that the atomic ratio of group (V) elements resulting from the nitrogen precursor to group (III) elements resulting from the aluminum precursor, and if present from the gallium precursor, in the gas stream is alternated between a first value of not more than 100 and a second value of not less than 200. In addition, the ratio of Al to Ga in the gas stream can be adjusted, in order to control the composition of the layers deposited in steps (iv) and (v). More preferably, the first value is not more than 50 and the second value is not less than 300. Most preferably, the first value is not less than 5 and not more than 50 and the second value is not less than 300 and not more than 500. In a particularly preferred embodiment, the first value is not less than 10 and not more than 30 and the second value is not less than 350 and not more than 400.

In one embodiment, the method is carried out in a reactor chamber having a total pressure of not less than 50 mbar and not more than 500 mbar throughout steps (ii) to (vii). The total pressure in the reaction chamber in step (v) is preferably not less than 50 mbar and not more than 300 mbar. Most preferably, the total pressure in the reaction chamber in step (v) is not less than 50 mbar and not more than 150 mbar.

The growth rate throughout steps (ii) to (v) is preferably in the range of 100 to 1500 nm/h. In steps (i) to (iii), the growth rate is more preferably in the range of 100 to 300 nm/h. Preferably, in step (v), the growth rate of AlₓGa₁₋ₓN is in the range of 100 to 500 nm/h and the growth rate of Al_{y}Ga_{1-y}N is in the range of 700 to 1300 nm/h. The growth rate can be influenced by adjusting the temperature, the flow rate, the total pressure in the reaction chamber and the precursor concentration in the gas flow. In step (vii), the gas stream is preferably adjusted according to the desired composition of the doped GaN layer for each layer to be deposited.

If the one or more monocrystalline, doped GaN layers of the semiconductor wafer comprise a p-doped GaN layer, the wafer can be optionally in-situ annealed in a hydrogen-free atmosphere. Preferably, in-situ annealing occurs at a temperature of not less than 700 and not more than 900°C. In-situ annealing allows electrical activation of the p-doped GaN layer, in particular of Mg-doped GaN layers.

### Example

A wafer comprising a multilayered structure according to the first aspect of the present invention is produced in the following manner using the method of producing a wafer according to the second aspect of the present invention:
A monocrystalline silicon substrate wafer with a <111>-orientation and with a diameter of 150 mm and thickness of 1000 µm is used as the substrate. The deposition of layers on the substrate by means of MOCVD was carried out in a commercially available vertical rotating disc reactor from Veeco Instruments. The pressure in steps (ii) to (v) was about 100 mbar and the pressure in steps(vi) and (vii) was about 200 mbar.

The nitride layers are deposited by metalorganic chemical vapour deposition (MOCVD) using trimethylgallium, trimethylaluminium, ethen, and ammonia as precursors and hydrogen and nitrogen as carrier gases. The deposition is carried out with the following parameters in this order:
The substrate is heated and annealed at 1050 °C to remove the surface oxide and potential surface contamination. A gas stream comprising an aluminum precursor and no nitrogen precursor is flown over the substrate at a temperature of not less than 700 °C and not more than 900 °C. A low temperature AIN nucleation layer having a thickness in the range of 1 nm to 50 nm is deposited at temperature in the range of 700°C to 900 °C followed by growth interruption. The temperature is ramped up to 1050 °C and a high temperature AIN nucleation layer having a thickness of 200 nm is deposited at 1050 °C followed by growth interruption.

The temperature is ramped down to 1010 °C and a 50 nm thick Al_{z}Ga_{1-z}N layer, with z=0.5, is deposited at 1010 °C followed by growth interruption. The amount of carbon incorporated can be controlled by modifying the flow of a carbon precursor ethene. The concentration of carbon is not less than 1 × 10¹⁸ cm⁻³ and not more than 1 × 10²⁰ cm⁻³.

AlₓGa₁₋ₓN (0.7 ≤ x ≤ 1) and Al_{y}Ga_{1-y}N (0 ≤ x ≤ 0.5) are alternately deposited 40 times, resulting in an average Al content of not more than 50 %. Before continuous flat layers are formed, islands are grown at the beginning of this step during the first 5 to 10 cycles.

The term continuous layer or closed layer within the meaning of the present invention refers to a uniform layer covering more than 90%, preferably more than 95%, and most preferably more than 98% of the underlying surface of the semiconductor wafer on which it is deposited. The term flat indicates that the layers run parallel to the main surface of the silicon substrate and are plain. As a result, the continuous flat layers form parallel lines when viewed from a direction perpendicular to the axial direction, for example by means of electron microscopy.

The thickness of the subsequently grown closed layers of AlₓGa₁₋ₓN and Al_{y}Ga_{1-y}N are in the range of 3-15 nm and 15-35 nm, respectively. The temperature during the deposition processes is not less than 1000°C and not more than 1100°C. The layer is intentionally doped with carbon. The concentration of carbon is preferably not less than 1 × 10¹⁸ cm⁻³ and not more than 1 × 10²⁰ cm⁻³.

A second sequence of alternating layers of AlₓGa₁₋ₓN (0.7 ≤ x ≤ 1) and Al_{y}Ga_{1-y}N (0 ≤ x ≤ 0.5) is deposited 80 times resulting in an average Al content of not more than 40 % in the superlattice. The thickness of the AlₓGa₁₋ₓN and Al_{y}Ga_{1-y}N layers are in the range of 3-15 nm and 15-35 nm, respectively. The temperature during the deposition processes is not less than 990°C and not more than 1050°C. The gas stream applied in this step comprises ethene as the carbon precursor. The concentration of carbon is preferably not less than 1 × 10¹⁸ cm⁻³ and not more than 1 × 10²⁰ cm⁻³.

A monocrystalline GaN buffer layer having a carbon concentration of not less than 1 × 10¹⁸ cm⁻³ and not more than 1 × 10²⁰ cm⁻³ and a thickness of 2 µm is deposited at a growth temperature of not less than 990°C and not more than 1050 °C. The gas stream used in this step comprises ethene as the carbon precursor.

A unintentionally doped GaN channel layer having a thickness of 500 nm is deposited. The growth temperature is not less than 1000 °C and not more than 1100°C. The carbon content in the GaN layer is not more than 5 × 10¹⁶ cm⁻³.

Subsequently, a AlGaN barrier layer having an Al content of 25 % and a thickness of 25 nm and a 1 nm thick GaN-cap are deposited at 1030 °C. Finally, the wafer is cooled down to room temperature.

The obtained structure is suitable for the use in lateral device structures and is well suited for 650 V applications.

## Claims

1. A wafer comprising a multilayered structure, wherein the multilayered structure comprises in this order
a silicon substrate;
a buffer structure; and
one or more monocrystalline device layers having a total thickness of not less than 80 nm and not more than 1000 nm and comprising at least one GaN layer;
the buffer structure comprising in this order
at least one AIN nucleation layer;
an Al_{z}Ga_{1-z}N layer;
at least one superlattice structure comprising 20 to 120 periods, each period consisting of a layer of AlₓGa₁₋ₓN and a layer of Al_{y}Ga_{1-y}N; and
a monocrystalline GaN buffer layer having a carbon concentration of not less than 1 × 10¹⁸ cm⁻³ and not more than 1 × 10²⁰ cm⁻³ and a thickness of not less than 0.5 µm and not more than 4 µm;
wherein 0.3≤z≤0.7; 0.6≤x≤1.0; and 0≤y≤0.4; and
**characterized in that**
at least one of the at least one superlattice structure comprises carbon in a concentration of not less than 1 × 10¹⁷ cm⁻³ and not more than 1 × 10²⁰ cm⁻³, and
the buffer structure comprises islands having a layered structure and consisting of alternating layers of AlₓGa₁₋ₓN and Al_{y}Ga_{1-y}N, the islands being located in-between the Al_{z}Ga_{1-z}N layer and the at least one superlattice structure consisting of alternating layers of AlₓGa₁₋ₓN and Al_{y}Ga_{1-y}N.

2. The wafer comprising a multilayered structure according to claim 1, wherein the multilayered structure is suitable for a lateral device structure.

3. The wafer comprising a multilayered structure according to claim 1 or 2, wherein the buffer structure comprises a first superlattice structure and a second superlattice structure atop the first superlattice structure.

4. The wafer comprising a multilayered structure according to any one of claims 1 to 3, wherein the buffer structure comprises a first superlattice structure and a second superlattice structure atop the first superlattice structure, wherein the average Al concentration in the second superlattice structure is lower than the average Al concentration in the first superlattice structure.

5. The wafer comprising a multilayered structure according to claim 3 or 4, wherein the second superlattice structure comprises carbon in a concentration of not less than 1 × 10¹⁸ cm⁻³ and not more than 1 × 10²⁰ cm⁻³.

6. The wafer comprising a multilayered structure according to any of claims 1 to 5, wherein the one or more monocrystalline device layers comprise in this order, a GaN channel layer, an AlᵥGa₁₋ᵥN barrier layer and optionally a cap layer, wherein 0.05≤v≤1.

7. The wafer comprising a multilayered structure according to any of claims 1 to 6, wherein the silicon substrate is a monocrystalline silicon wafer having a <111>-orientation, a wafer comprising a silicon on insulator (SOI) structure having a <111>-orientation, or a ceramic substrate with a silicon seed layer having a <111>-orientation.

8. The wafer comprising a multilayered structure according to any of claims 1 to 7, wherein each period of the at least one superlattice structure has a thickness of not less than 15 nm and not more than 50 nm.

9. The wafer comprising a multilayered structure according to any of claims 1 to 8, wherein the total thickness of the at least one AIN nucleation layer is not less than 50 nm and not more than 500 nm.

10. Method of producing a wafer comprising a multilayered structure, the method comprising the following steps in this order
(i) providing a silicon substrate;
(ii) flowing a gas stream which comprises an aluminum precursor and no nitrogen precursor over the substrate at a temperature of not less than 700 °C and not more than 900 °C so that the total amount of aluminum flown over the substrate is not less than 0.1 µmol and not more than 250 µmol;
(iii) depositing at least one AIN nucleation layer by flowing a gas stream comprising an aluminum precursor and a nitrogen precursor over the substrate at a temperature of not less than 700 °C and not more than 1100 °C;
(iv) depositing an Al_{z}Ga_{1-z}N layer with 0.3≤z≤0.7 by flowing a gas stream comprising an aluminum precursor, a gallium precursor and a nitrogen precursor over the substrate at a temperature of not less than 950 °C and not more than 1050 °C;
(v) depositing alternately AlₓGa₁₋ₓN with 0.6≤x≤1.0 and Al_{y}Ga_{1-y}N with 0≤y≤0.4 for 20 to 120 cycles by flowing a gas stream comprising an aluminum precursor, a gallium precursor and a nitrogen precursor over the substrate at a temperature of not less than 900°C and not more than 1100°C, wherein the alternation of the deposition is achieved by changing the composition of the gas stream; and
(vi) depositing a monocrystalline GaN buffer layer by flowing a gas stream comprising a gallium precursor, a nitrogen precursor and a carbon precursor over the substrate at a temperature of not less than 950°C and not more than 1100°C;
(vii) depositing one or more monocrystalline GaN device layers by flowing a gas stream comprising a gallium precursor, a nitrogen precursor and optionally a dopant precursor over the substrate at a temperature of not less than 900°C and not more than 1200°C;
**characterized in that** in at least one of steps (iv) and (v) the gas stream additionally comprises a metal-free carbon precursor.

11. The method of producing a wafer comprising a multilayered structure according to claim 10, wherein step (v) is carried out twice in a row so that a first superlattice structure and a second superlattice structure are formed.

12. The method of producing a wafer comprising a multilayered structure according to claim 10 or 11, wherein, in each of steps (ii) to (iv), the gas stream satisfies an atomic ratio of group (V) elements resulting from the nitrogen precursor to group (III) elements resulting from the aluminum precursor of not less than 5 and not more than 500.

13. The method of producing a wafer comprising a multilayered structure according to any one of claims 10 to 12, wherein the alternation of the deposition in each cycle of step (v) is achieved by changing the composition of the gas stream so that the atomic ratio of group (V) elements resulting from the nitrogen precursor to group (III) elements resulting from the aluminum precursor and, if applicable, the gallium precursor, in the gas stream is alternated between a first value of not more than 100 and a second value of not less than 200.

14. The method of producing a wafer comprising a multilayered structure according to any one of claims 10 to 13, wherein the method is carried out in a reactor chamber having a total pressure of not less than of 50 and not more than 300 mbar throughout steps (ii) to (vii).

15. The method of producing a wafer comprising a multilayered structure according to any one of claims 10 to 14, wherein in step (v) the growth rate of AlₓGa₁₋ₓN is in the range of 100 to 500 nm/h and the growth rate of Al_{y}Ga_{1-y}N is in the range of 700 to 1300 nm/h.
